# FASCICULE DE BREVET EUROPEEN

(11) **EP 2 747 452 B1**
(45) Date de publication et mention de la délivrance du brevet: **11.01.2017**
(21) Numéro de dépôt: 13197764.7
(22) Date de dépôt: 17.12.2013
(51) Int. Cl.: H04R 3/00, H04R 19/00, H04R 1/00

(54) **Dispositif à membrane à déplacement contrôlé**
Membranvorrichtung mit kontrollierter Bewegung
Membrane device with controlled movement

(30) Priorité: 20.12.2012 FR 1262378
(43) Date de publication de la demande: 25.06.2014
(73) Titulaire: Commissariat à l'Énergie Atomique et aux Énergies Alternatives, 75015 Paris (FR)
(72) Inventeur: Fanget, Stéphane, 38690 Le Grand Lemps (FR); Dejaeger, Rémy, 69210 Eveux (FR); Robert, Philippe, 38000 Grenoble (FR)
(74) Mandataire: Ahner, Philippe

(56) Documents cités:
- GB-A- 2 089 171
- US-A- 4 607 382
- US-B1- 6 807 279
- THOR BAKKE ET AL: "A novel ultra-planar, long-stroke and low-voltage piezoelectric micromirror", JOURNAL OF MICROMECHANICS & MICROENGINEERING, INSTITUTE OF PHYSICS PUBLISHING, BRISTOL, GB, vol. 20, no. 6, 1 juin 2010 (2010-06-01), page 64010, XP020175452, ISSN: 0960-1317

## Description

### DOMAINE TECHNIQUE ET ART ANTÉRIEUR

La présente invention se rapporte à un dispositif comportant une membrane dont le déplacement est contrôlé, particulièrement adapté à la réalisation d'un haut-parleur digital.

Une membrane suspendue permet de réaliser notamment un capteur de pression ou un générateur de pression tel qu'un transducteur électroacoustique.

Le haut-parleur digital comporte un ensemble de transducteurs électroacoustiques de taille réduite appelés "speaklet" et qui sont disposés en matrice. Chaque speaklet émet des pulses de pression à une fréquence appelée "fréquence de reconstruction".

Grâce à la technologie MEMS il est possible de fabriquer un grand nombre de speaklets sur une surface réduite tout en assurant une distance inter-speaklet non nulle.

Afin de reconstituer de manière satisfaisante le son, l'accélération de la membrane de chaque speaklet doit être contrôlée précisément.

Le document Bakke et al. « A novel ultra planar, long-stroke and low-voltage piezoelectric micromirror », J. Micromech. Microeng. 20 (2010*)* décrit un micro-miroir actionné par des actionneurs piézoélectriques.

Le micro-miroir est solidaire d'une membrane qui est déplaçable au moyen de deux actionneurs. Un premier actionneur annulaire situé au bord de la membrane et un deuxième actionneur de forme annulaire situé dans la partie centrale de la membrane.

L'un des actionneurs imprime à la membrane un mouvement vers le haut et l'autre actionneur imprime à la membrane un mouvement vers le bas.

Le déplacement de la membrane n'est pas contrôlé en ce sens qu'il n'y a aucun contrôle dynamique de la position de la membrane, ni aucun moyen pour arrêter la membrane.

Des butées peuvent être prévues pour arrêter la membrane cependant du fait du contact mécanique, des problèmes de fiabilité peuvent subvenir.

Par ailleurs, les butées ayant des dimensions définies lors de la réalisation du dispositif, celles-ci ne permettent pas de contrôle dynamique de la position de la membrane.

### EXPOSÉ DE L'INVENTION

C'est par conséquent un but de la présente invention d'offrir un dispositif à membrane dont le déplacement dynamique est contrôlé.

Le but précédemment énoncé est atteint par un dispositif comportant une membrane suspendue, deux actionneurs ainsi que des moyens de mesure de la position de la membrane. Lorsque l'un des actionneurs met en mouvement la membrane, le second permet de contrôler ce mouvement en appliquent une force qui est fonction de la position et qui peut également être fonction de la vitesse et/ou de l'accélération de la membrane.

En d'autres termes, on utilise un deuxième actionneur pour maintenir la membrane dans une position donnée dans le cas d'un contrôle dynamique ou pour amortir le déplacement de la membrane.

Les moyens de mesure de la position de la membrane sont par exemple de type capacitif, piézoélectrique ou piézorésistif.

De manière très avantageuse, les moyens pour mesurer la position de la membrane sont au moins en partie portés par la membrane, le dispositif à membrane présente alors un haut niveau d'intégration.

Les moyens de commande utilisent par exemple une boucle de rétroaction négative qui permet de générer un amortissement.

La présente invention a alors pour objet un dispositif à membrane comportant un support, une membrane suspendue sur le support, un premier actionneur en contact avec la membrane destiné à exercer un effort sur la membrane, un deuxième actionneur en contact avec la membrane destiné à exercer un effort sur la membrane, des moyens de détermination de la position de la membrane par rapport au support et des moyens de commande des premier et deuxième actionneurs, lesdits moyens de commande appliquant un signal de déformation à l'un des premier et deuxième actionneurs pour déplacer la membrane et appliquant un signal de contrôle à l'autre des premier et deuxième actionneurs pour contrôler le déplacement de la membrane, l'application du signal de contrôle étant déterminée au moins par la position de la membrane.

Le déplacement de la membrane peut ne pas être homogène. Ainsi la membrane déplacée peut prendre des formes complexes notamment avec des parties concaves et/ou convexes.

De manière très avantageuse, les moyens de détermination de la position de la membrane sont au moins en partie portés par la membrane.

Le signal de contrôle peut être en outre déterminé par la vitesse et/ou l'accélération du déplacement de la membrane.

De préférence, les premier et deuxième actionneurs sont du type piézoélectrique.

D'autres types d'actionneurs peuvent également être utilisés, notamment des actionneurs présentant un effet bilame tels que des actionneurs thermomécaniques.

Dans un exemple de réalisation, les premier et deuxième actionneurs peuvent alors comporter un matériau piézoélectrique ferroélectrique, chacun des premier et deuxième actionneurs étant destinés à déformer la membrane dans un sens opposé.

Dans un autre exemple de réalisation, les premier et deuxième actionneurs comportent un matériau piézoélectrique non ferroélectrique, l'un des premier et deuxième actionneurs étant destiné à déformer la membrane dans un premier et un deuxième sens opposés et l'autre des premier et deuxième actionneurs étant destiné à contrôler le déplacement de la membrane en la déformant dans un sens opposé au sens de la déformation induite par l'autre actionneur.

Le premier et le deuxième actionneur peuvent comporter respectivement un matériau piézoélectrique disposé entre deux électrodes.

De préférence, la reprise de contact des actionneurs pour le premier actionneur et pour le deuxième actionneur sont réalisés en dehors de la partie suspendue de la membrane.

Dans un exemple de réalisation, la membrane a une forme de disque, le premier actionneur a une forme d'anneau centré sur la membrane et le deuxième actionneur a la forme d'un disque situé sensiblement dans une zone centrale de la membrane.

La membrane a de préférence une forme de disque sensiblement circulaire ou même elliptique mais peut avoir d'autres formes, par exemple une forme carrée. Par ailleurs les actionneurs sont de préférence disposés de manière concentrique sur la membrane et peuvent prendre des formes variées, différentes des formes circulaires et elliptiques.

L'actionneur central n'est pas disposé sur la partie de la membrane ancrée au support. Lorsque cet actionneur a une forme de disque circulaire ou elliptique, il peut être plein ou évidé et lorsque l'actionneur extérieur a une forme en anneau, l'anneau peut être aussi circulaire ou elliptique. Ainsi, selon l'invention les actionneurs peuvent avoir respectivement des formes plus complexes et en particulier comporter des secteurs reliés électriquement entre eux. Dans un autre exemple de réalisation, la membrane a une forme de disque, le premier actionneur a une forme annulaire centré sur la membrane, le premier actionneur comportant une couronne et une pluralité d'ailettes de forme sensiblement trapézoïdale reliées à la couronne par leur grande base, et le deuxième actionneur a la forme d'un disque situé sensiblement dans une zone centrale de la membrane.

De préférence, le rapport entre la surface du deuxième actionneur et la surface de la membrane est compris entre 0,2 et 0,5 et de préférence le rapport entre la surface de la partie du premier actionneur en contact avec la membrane et la surface de la membrane est compris entre 0,4 et 0,75.

Les moyens de commande peuvent comporter une boucle de rétroaction négative.

Les moyens de détermination de la position de la membrane peuvent être de type piézoélectrique par effet direct. Les moyens de détermination de la position de la membrane peuvent être formés par des électrodes du premier et/ou du deuxième actionneur, une polarisation électrique sous l'effet de la déformation de la membrane étant mesurée entre les électrodes du premier actionneur et/ou entre les électrodes du deuxième actionneur.

Alternativement, les moyens de détermination de la position de la membrane peuvent être de type capacitif.

Selon l'invention, on peut réaliser une redondance des moyens de détermination en utilisant par exemple des moyens de type capacitif et/ou piézoélectrique.

Le dispositif peut comporter un substrat sur lequel est reporté le support, ledit substrat comportant au moins une électrode en regard de la membrane, les moyens de détermination de la position de la membrane mesurant la variation de capacité entre la membrane et ladite électrode sur le substrat

En variante, les moyens de détermination de la position de la membrane sont de type piézorésistif.

Le dispositif à membrane selon l'invention, peut être réalisé par des procédés de la microélectronique.

La présente invention a également pour objet un haut-parleur digital comportant au moins un dispositif à membrane selon l'invention.

Le haut-parleur digital peut comporter avantageusement une pluralité de dispositifs à membrane de taille micrométrique.

La présente invention a également pour objet un procédé de contrôle de l'actionnement d'un dispositif à membrane selon l'invention comportant les étapes :
a) application d'un signal de déformation à l'un des premier et deuxième actionneurs,
b) détermination de la position de la membrane,
c) détermination d'un signal de contrôle,
d) application dudit signal de contrôle à l'autre des premier et deuxième actionneurs.

Le signal de déformation et le signal de contrôle peuvent être des tensions.

Par exemple, la détermination de la position de la membrane se fait par mesure d'une polarisation aux bornes du premier et/ou du deuxième actionneur ou de la capacité entre la membrane et au moins une électrode déposée sur le support.

### BRÈVE DESCRIPTION DES DESSINS

La présente invention sera mieux comprise à l'aide de la description qui va suivre et des dessins en annexes sur lesquels :
- les figures 1A et 1B sont des vues en perspective et en coupe d'un exemple de dispositif à membrane,
- les figures 1C et 1D sont des vues en coupe du dispositif à membrane des figures 1A et 1B dans deux positions différentes,
- la figure 1E est une vue de côté d'une variante du dispositif à membrane des figures 1A et 1B,
- la figure 2 est une vue de dessus de l'actionneur de la figure 1A,
- la figure 3 est une vue de dessus de la membrane munie d'actionneurs selon une variante de réalisation,
- la figure 4 est un exemple d'une boucle de rétroaction négative mise en oeuvre dans la commande du dispositif à membrane,
- les figures 5A et 5B sont des représentations graphiques de la commande en tension de l'actionneur d'un dispositif à membrane de l'état de la technique et de la vitesse de déplacement de la membrane respectivement,
- les figures 6A et 6B sont des représentations graphiques de la commande en tension de l'actionneur d'un dispositif à membrane selon l'invention et de la vitesse de déplacement de la membrane respectivement,
- les figures 7A à 7F sont des représentations schématiques des différentes étapes d'un exemple de procédé de réalisation d'un dispositif à membrane selon l'invention,
- la figure 8A est une représentation graphique d'un signal de déplacement appliqué à un dispositif à membrane de l'état de la technique et la réponse de la membrane en fonction du temps,
- la figure 8B est une représentation graphique des signaux appliqués aux actionneurs d'un dispositif à membrane selon la présente invention et la réponse de la membrane en fonction du temps.

### EXPOSÉ DÉTAILLÉ DE MODES DE RÉALISATION PARTICULIERS

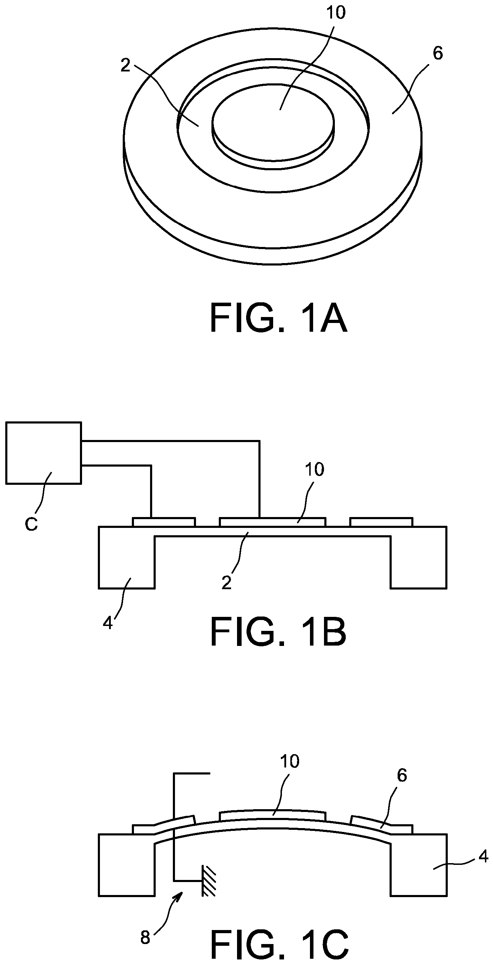

Sur les figures 1A et 1B, on peut voir un exemple d'un dispositif à membrane comportant une membrane 2 sous forme de disque suspendu sur un support 4, un élément en matériau piézoélectrique 6 en forme d'anneau situé sur une face supérieure de la membrane 2 et sur le bord extérieur de la membrane 2.

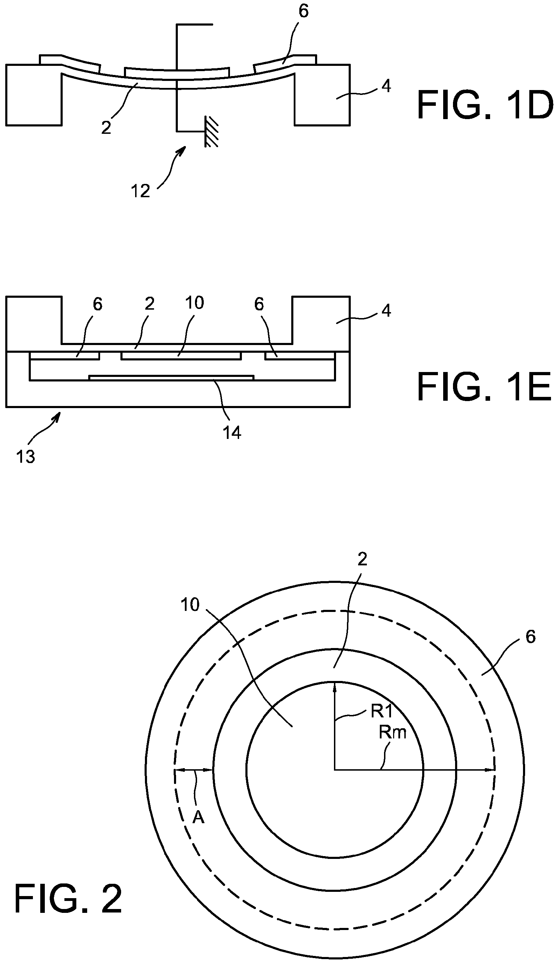

La périphérie extérieure de l'anneau 6 est sur le support 4 et la périphérie intérieure est sur la membrane 2. L'anneau est connecté à une source de tension ou de courant 8 comme cela est schématisé sur les figures 1C et 1D de sorte qu'il forme un premier actionneur apte à mettre en mouvement la membrane 2. Pour cela, une électrode est prévue sur chaque face de l'anneau 6 pour assurer sa connexion à la source de tension 8.

Le dispositif à membrane comporte également un deuxième élément en matériau piézoélectrique 10 sous forme de disque dans l'exemple représenté, et situé dans une partie centrale de la face supérieure de la membrane 2. Le disque 10 est également connecté à une source de tension ou de courant 12 comme cela est schématisé sur les figures 1C et 1D de sorte qu'il forme un deuxième actionneur apte à mettre en mouvement la membrane 2. Une électrode est prévue sur chaque face de l'anneau pour assurer sa connexion à la source de tension 8.

En variante, l'actionneur peut présenter une autre forme, par exemple en forme d'anneau.

Dans une autre variante, la membrane peut présenter une forme carrée ou rectangulaire, dans ce cas l'actionneur peut avoir une forme similaire à celle de la membrane mais avec une surface différente.

Il est à noter que le deuxième actionneur ne présente aucune partie de sa surface ancrée sur la partie support.

Les premier et deuxième actionneurs peuvent être réalisés avec les mêmes matériaux piézoélectriques avec des matériaux piézoélectriques différents.

Dans un exemple de réalisation, les actionneurs sont réalisés à partir de matériaux piézoélectriques ferroélectriques tels que le PZT. Les déplacements de la membrane obtenus grâce à ces actionneurs sont ceux représentés sur les figures 1C et 1B.

En effet, quelle que soit le signe de la tension appliquée, si celle-ci est supérieure en valeur absolue au champ coercitif du matériau piézoélectrique ferroélectrique, alors celui-ci se dilate dans l'épaisseur et se contracte radialement. Par conséquent, les déplacements vers le haut ou vers le bas de la membrane sont provoqués par la forme et la position de l'actionneur sur la membrane et non par le signe de la tension de commande.

Dans l'exemple représenté, l'application d'une tension sur le premier actionneur 6 provoque un déplacement de la membrane 2 vers le haut, elle présente alors une forme convexe par rapport au support 4. L'application d'une tension sur le deuxième actionneur 10 provoque un déplacement de la membrane 2 vers le bas qui présente alors une forme concave par rapport au support 4.

Dans un autre exemple de réalisation, les actionneurs sont réalisés à partir de matériaux piézoélectriques non ferroélectriques comme par exemple AIN, ZnO... Une tension positive provoque la dilatation du matériau piézoélectrique alors qu'une tension négative va induire sa contraction. Ainsi les déplacements vers le haut et le bas peuvent être obtenus en utilisant un seul actionneur. Dans cet exemple de réalisation, un actionneur peut être dédié aux déplacements de la membrane et un actionneur peut être dédié au contrôle dynamique de la membrane en la déformant dans un sens opposé au sens de la déformation induite par l'autre actionneur.

L'amplitude du déplacement de la membrane est proportionnelle à la tension appliquée aux bornes des actionneurs.

De préférence, le rapport entre la surface du deuxième actionneur 10 et de la surface de la membrane 2 est compris entre 0,2 et 0,5 et le rapport entre la surface du premier actionneur 6 qui est située sur la membrane 2 et la surface de la membrane 2 est compris entre 0,4 et 0,75.

A titre d'exemple, en considérant Rm le rayon de la membrane 2, R1 le rayon du deuxième actionneur 10, A la largeur de la partie annulaire du premier actionneur 6 située sur la membrane 2 :
- Rm est compris entre 100 µm et 7500 µm, et/ou
- R1 est compris entre de 25 µm et 5000 µm, et/ou
- A est comprise entre 25 µm et 5000 µm.

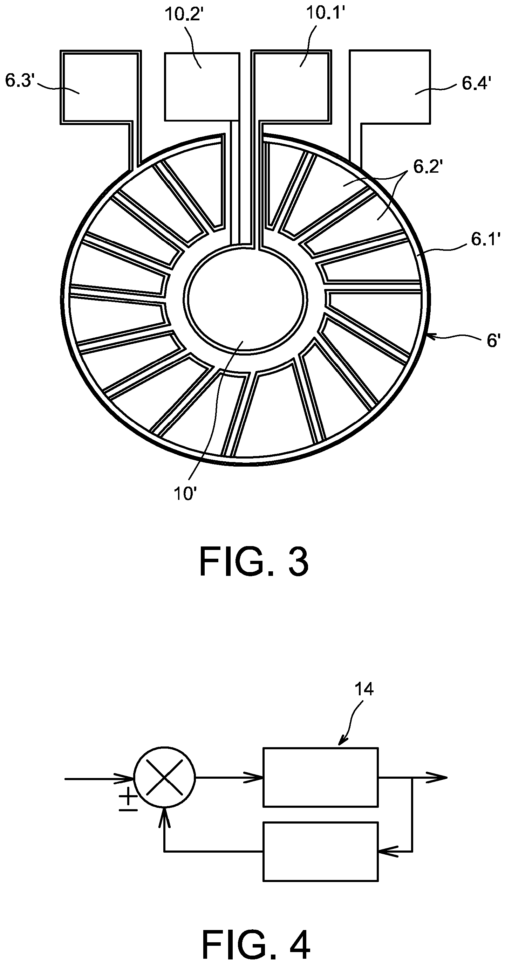

Sur la figure 3, on peut voir un autre exemple de réalisation d'un dispositif selon l'invention vu de dessus. Dans cet exemple, le premier actionneur 6' comporte un couronne 6.1' délimitant le diamètre extérieur du premier actionneur et une pluralité d'ailettes 6.2' de forme par exemple sensiblement trapézoïdale reliées à la couronne par leur plus grande base. Le deuxième actionneur 10' est en forme de disque déposé sur la partie centrale de la membrane.

Sont représentés les plots de contact 6.1', 6.2' des électrodes supérieure et inférieure respectivement du premier actionneur 6'.

Sont représentés les plots de contact 10.1', 10.2' des électrodes supérieure et inférieure respectivement du deuxième actionneur 10'.

En variante, on peut envisager de mettre en oeuvre des actionneurs de type thermique, destinés à échauffer par exemple la membrane et provoquer sa dilatation et donc son déplacement.

Le dispositif à membrane comporte également des moyens de détermination (non représentés) de la position de la membrane 2.

Les moyens de détermination sont par exemple de type piézoélectrique, capacitif ou piézorésistif.

De préférence, les moyens de détermination de la position de la membrane sont au moins en partie portés par la membrane, les mesures ainsi obtenues sont très précises, puisqu'elles mesurent directement la position de la membrane.

Dans un exemple de réalisation, les moyens de détermination mesurent une polarisation électrique entre les électrodes d'un ou des actionneurs 6, 10.

En effet, la déformation de la membrane a pour effet d'appliquer une contrainte sur le matériau piézoélectrique qui génère alors une polarisation électrique, cette polarisation électrique est alors représentative d'une position donnée de la membrane. Ces moyens de cet exemple présentent l'avantage d'utiliser les électrodes déjà existantes. Le dispositif présente alors un haut niveau d'intégration.

La mesure peut être effectuée entre les électrodes du premier actionneur et /ou les électrodes du deuxième actionneur.

Dans une variante de réalisation où la membrane 2 et son support 4 sont reportés sur un support 13 (voir Figure 1E), les moyens de détermination sont de type capacitif, ils mesurent la capacité entre la membrane 2 et la partie du support 13 par exemple une électrode 14 en regard de la membrane 2. La valeur de la capacité est directement proportionnelle à la distance séparant la membrane 2 du support 13.

On peut envisager de mesurer à la fois la polarisation électrique entre deux électrodes de l'un ou des deux actionneurs et la capacité entre la membrane et le support 13 afin d'augmenter la fiabilité de la détermination de la position de la membrane.

Le dispositif comporte en outre des moyens de commande C, représentés schématiquement sur la figure 1B, de l'un ou des deux actionneurs 6, 10 en fonction de la position évaluée de la membrane obtenue par les moyens de détermination, pour asservir la position de la membrane, en appliquant une tension donnée à l'un des actionneurs.

Les moyens de commande peuvent comporter une boucle de rétroaction négative 14 représentée sur la figure 4, qui provoque l'amortissement du déplacement de la membrane. Ce type de boucle est bien connu de l'homme du métier et ne sera pas décrit en détail.

Le fonctionnement d'un dispositif à membrane de l'état de la technique et le fonctionnement d'un dispositif à membrane selon l'invention vont être décrits.

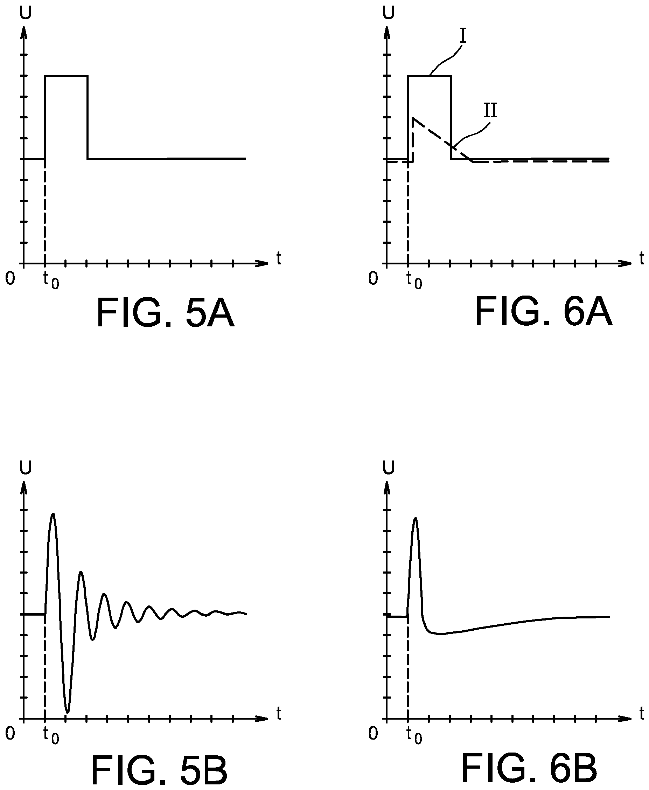

Sur la figure 5A, on peut voir représenté graphiquement une commande en tension U en créneau en fonction du temps t d'un dispositif à membrane de l'état de la technique comportant deux actionneurs commandés séparément, l'actionneur extérieur provoquant le déplacement de la membrane vers le haut et l'actionneur intérieur provoquant le déplacement de la membrane vers le bas. Un tel dispositif ne comporte aucun moyen de contrôle du déplacement de la membrane, Sur la figure 5B est représentée l'évolution de la vitesse V au centre de la membrane d'un tel dispositif en fonction du temps t.

On constate qu'au temps t0 où une tension est appliquée à l'actionneur, la vitesse de la membrane augmente fortement vers sa deuxième position, puis diminue en présentant des lobes secondaires. La membrane oscille donc jusqu'à dissiper l'énergie fournie par l'actionneur. On constate donc que l'arrêt de la membrane n'est pas contrôlé.

Sur la figure 6A, on peut voir les signaux de commande en tension U en fonction du temps t émis pas les moyens de contrôle d'un dispositif à membrane selon la présente invention. Nous considérons un dispositif tel que représenté sur les figures 1A à 1D, le matériau piézoélectrique des actionneurs étant ferroélectrique. Le premier actionneur 6 provoque le déplacement de la membrane 2 vers le haut et le deuxième actionneur 10 provoque le déplacement de la membrane 2 vers le bas.

Le signal I est celui appliqué au premier actionneur 6 et le signal II est celui appliqué au deuxième actionneur 10.

Lors d'une première étape, le signal I est appliqué au premier actionneur 6. La membrane est déformée vers le haut dans la représentation de la figure 1D.

Lors d'une étape suivante, la position de la membrane 2 est évaluée par les moyens de détermination soit en mesurant la polarisation électrique soit entre les deux électrodes d'au moins l'un des actionneurs, soit en mesurant la capacité entre la membrane et le substrat.

Lors d'une étape suivante, un signal II à appliquer au deuxième actionneur 10 est déterminé en fonction de la position de la membrane 2 et de la commande à appliquer à la membrane 2 et le signal II est appliqué au deuxième actionneur 10 à un instant t qui correspond à la position souhaitée de la membrane.

Si on dispose d'un modèle prédictif du comportement de la membrane, le signal II peut être déterminé directement à partir de l'information sur la position de la membrane.

En l'absence de ce modèle, les mesures de position peuvent être dérivées une première fois pour obtenir la vitesse et une seconde fois pour obtenir l'accélération de la membrane, le signal II est alors établi par exemple sur la base de l'accélération puisque la pression acoustique que l'on souhaite contrôler est directement proportionnelle à l'accélération de la membrane.

Dans l'exemple de la figure 6A, le signal II est appliqué au deuxième actionneur peu de temps après le signal I appliqué au premier actionneur, le signal II est tel qu'il a pour effet de raidir la membrane. Il résulte de l'application du signal II que les lobes secondaires sont supprimés dans la réponse en vitesse au centre de la membrane.

Si on maintient le signal I sur le premier actionneur 6 alors que l'on applique le signal II sur le deuxième actionneur 10, la membrane 2 est maintenue dans la position déformée obtenue par le premier actionneur 6 grâce à l'action du deuxième actionneur 10.

Si on ne maintient pas le signal I lorsque l'on applique le signal II sur le deuxième actionneur 10, la membrane 2 retrouve sa position d'équilibre mais de manière amortie.

On constate que la membrane 2 à t0 prend une vitesse élevée et que celle-ci est très rapidement amortie. La position de la membrane 2 est alors précisément contrôlée.

Le fonctionnement est similaire lorsqu'on applique le signal I au deuxième actionneur 10 pour déplacer la membrane et le signal II au premier actionneur pour contrôler le déplacement de la membrane.

Cette forme de signal de vitesse induit une accélération et donc un signal de pression de forme similaire sans lobes de pression secondaires, ce qui est particulièrement adapté pour un haut-parleur digital où les lobes de pressions secondaires sont gênants dans la reconstruction du son.

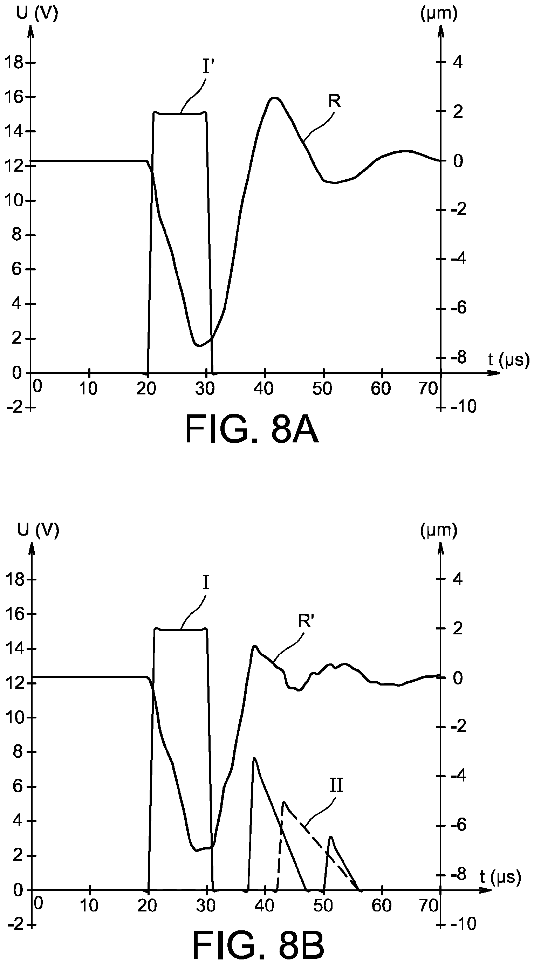

Sur la figure 8A, on peut voir un autre exemple de simulation par élément finis de la réponse de la membrane dans le cas d'un dispositif muni uniquement d'un actionneur interne. Sur l'axe des ordonnées de gauche il s'agit de la tension en V et sur l'axe des ordonnées de droite il s'agit du déplacement en µm. La courbe I' représente le signal appliqué à l'actionneur et la courbe R représente le déplacement de la membrane au cours du temps.

Sur la figure 8B, on peut voir un autre exemple de simulation par éléments finis de la réponse de la membrane dans le cas d'un signal I plus complexe que celui de la simulation de la figure 6A. La courbe R' représente le déplacement de la membrane au cours du temps.

Dans cette simulation, le signal I est appliqué au deuxième actionneur 10 et le signal II de contrôle est appliqué au premier actionneur 6. Dans cet exemple, le signal II est appliqué environ 22 µs après le signal I.

On constate une diminution des lobes secondaires.

Grâce à l'invention, il est possible d'affiner la réponse dynamique de la membrane en ajustant le pulse d'actionnement initial, comme sur le pulse de contre réaction. La combinaison de ces pulses permet de supprimer les lobes secondaires.

La loi de commande de la membrane est par exemple déterminée en effectuant une étude par simulation par éléments finis de la réponse de la membrane en fonction de l'amplitude et de la durée des signaux ainsi que le temps entre les signaux.

Il sera compris que les formes des signaux de tension, ainsi que leurs amplitudes ou leur décalage temporel ne sont pas limités au cas illustré par les représentations graphiques de les figures 6A et 8A.

A titre d'exemple, le temps écoulé entre l'application du signal I et l'application du signal II peut être compris entre 5µs et 5ms.

Le signal de commande du deuxième actionneur est fixé en fonction de l'évaluation de la position de la membrane obtenue suivant le cas par la mesure capacitive ou par la mesure de la polarisation électrique.

Dans l'exemple de réalisation où le matériau piézoélectrique des actionneurs est non ferroélectrique, l'un des actionneurs peut ne servir qu'au déplacement vers le haut et vers le bas de la membrane en fonction du signe de la tension appliquée à l'actionneur et l'autre actionneur peut ne servir qu'à réguler la position de la membrane.

Dans un système comportant une pluralité de dispositifs à membrane, des signaux peuvent être appliqués à chaque dispositif séparément, ou à des groupes de dispositifs ou à tous les dispositifs en fonction de l'utilisation d'un tel système.

Par exemple, dans le cas du haut-parleur digital, le son est reconstruit en additionnant les contributions élémentaires des speaklets. Dans certains cas, aucun speaklet ne peut être actionné, dans d'autres cas un certain pourcentage de speaklets est actionné, et dans d'autres cas tous les speaklets sont actionnés. Le dispositif à membrane selon l'invention peut être utilisé dans de nombreux domaines techniques. Par exemple, il peut être utilisé pour réaliser un capteur ou un générateur de pression, un haut parleur digital plus performant puisque, grâce à l'invention, la vibration parasite de la membrane est diminuée ce qui permet d'améliorer le son résultant, un générateur de pulses ultrasonores comme les cMUT, des objets médicaux devant délivrer une quantité de produit très précise, éventuellement en un temps donné comme une pompe à insuline,..., dans l'imagerie ultrasonore, dans la réalisation de composants RF , tels qu'une capacité variable pour laquelle on souhaite contrôler précisément dans le temps la valeur de la capacité.

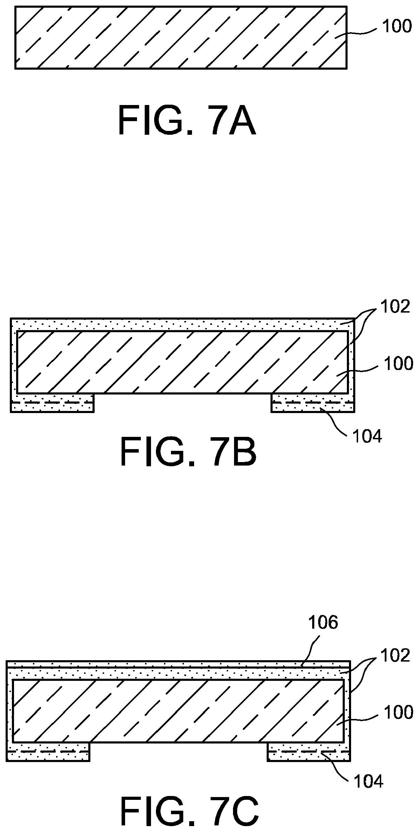

Un exemple de procédé de réalisation d'un dispositif à membrane va être décrit. Les étapes sont représentées schématiquement sur les figures 7A à 7F.

Par exemple, on utilise un substrat en silicium 100 représenté sur la figure 7A.

Lors d'une première étape, on effectue une oxydation thermique du substrat de sorte à former une couche d'oxyde 102 sur toutes les surfaces du substrat d'une épaisseur de 2 µm par exemple. Ensuite, on réalise un dépôt d'un masque dur d'oxyde 104 sur la face arrière du substrat. Ce masque a par exemple une épaisseur de 5 µm. le masque est réalisé en retournant le substrat; en fonction de la composition de dépôt choisie; il est possible de ne déposer le masque que sur cette face. Il peut s'agir par exemple d'un dépôt de type PVD (Physical Vapor Deposition en terminologie anglo-saxonne)

On effectue ensuite une gravure en face arrière de sorte à atteindre le silicium.

L'élément ainsi obtenu est représenté sur la figure 7B.

Lors d'une étape suivante, on forme une couche 106 en face avant destinée à former la membrane 2. Cette couche est par exemple en polysilicium, en SiC ou en SiO₂. L'épaisseur de la couche 106 est par exemple comprise entre quelques centaines de nm à plusieurs µm, voire plusieurs dizaines de µm.

La couche 106 est par exemple réalisée par dépôt chimique en phase vapeur (ou CVD pour l'anglais chemical vapor deposition) ou par croissance épitaxiale. De préférence, les contraintes de la couche 106 sont maîtrisées.

L'élément ainsi obtenu est représenté sur la figure 7C.

Lors d'une étape suivante, on forme une couche 108 sur la couche 106 par exemple en SiO₂ ou en SiN. La couche 108 a par exemple une épaisseur comprise entre quelques centaines de nm et plusieurs µm. la couche 108 est formée par exemple par oxydation thermique ou par dépôt CVD.

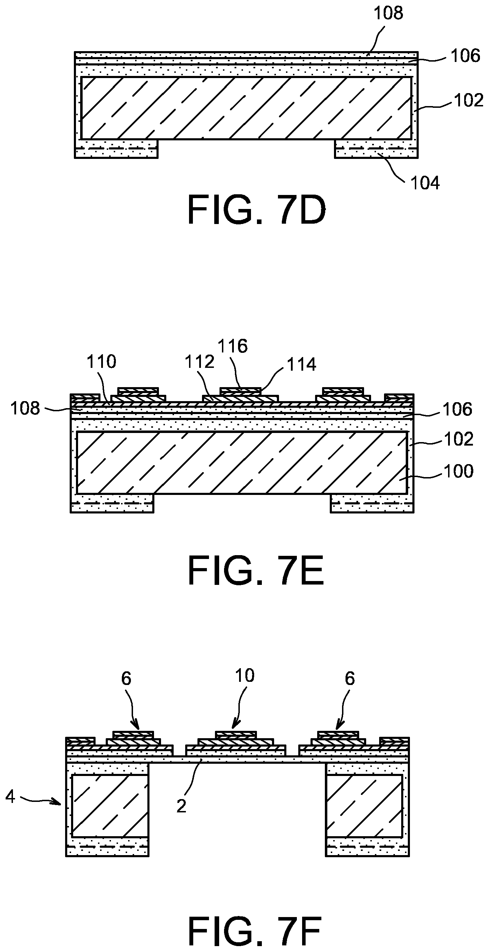

L'élément ainsi obtenu est représenté sur la figure 7D.

Lors d'une étape suivante, on réalise les premier et deuxième actionneurs.

Pour cela on réalise tout d'abord une couche 110 destinée à former les électrodes inférieures des actionneurs, par exemple en Pt, Mo. La couche 110 est réalisée par exemple par dépôt sur la couche 108. La couche 110 a par exemple une épaisseur comprise entre quelques dizaines de nm à quelques centaines de nm.

Une couche de matériau piézoélectrique 112 est ensuite déposée sur la couche 110, par exemple en PZT, AIN, ZnO, LNO dont l'épaisseur est par exemple comprise entre quelques centaines de nm à quelques µm.

On réalise ensuite l'électrode supérieure par formation d'une couche 114 sur le matériau piézoélectrique 112, par exemple en Ru, Au par exemple d'épaisseur comprise entre quelques dizaines de nm à quelques centaines de nm.

De préférence une couche supplémentaire 116, par exemple en or, est déposée sur la couche des électrodes supérieures destinées à assurer la reprise des contacts sur les électrodes supérieures.

A lieu ensuite une étape de gravure.

De préférence, on réalise un profil en escalier. Celui-ci est obtenu car toutes les couches sont déposées puis gravées, à partir de la couche supérieure, en utilisant des masques de photolithographie différents, le deuxième masque étant plus large que le premier, etc. Cela permet de laisser des marges de sécurité pour éviter le recouvrement de couches, qui pourrait apparaître du fait de l'incertitude de positionnement des masques. On évite ainsi tout court circuit électrique entre les électrodes.

Dans l'exemple représenté et de manière avantageuse, on réalise par exemple simultanément, des plots de contact 18 de l'électrode inférieure sur le bord extérieur de l'électrode inférieure. Les matériaux conducteurs de l'électrode supérieure sont également empilés sur l'électrode inférieure, ce qui permet de ne pas avoir trop de différence d'épaisseur entre les plots des électrodes inférieure et supérieure. Une différence trop importante pourrait engendrer des problèmes de caractérisation.

L'élément ainsi obtenu est représenté sur la figure 7E. Les plots de contact sont par exemple les plots de contact 6.3', 6.4' et 10.1', 10.2'représentés schématiquement sur la figure 3.

On grave ensuite l'électrode inférieure, et ensuite la couche 108 en utilisant par exemple le même masque de photolithographie. La gravure est arrêtée sur la membrane 106

Enfin, on libère la membrane par gravure profonde du substrat par la face arrière jusqu'à atteindre la membrane.

Le dispositif à membrane ainsi obtenu est visible sur la figure 7F, celui-ci comporte la membrane 2 suspendue sur le support 4 et le premier actionneur annulaire 6 et le deuxième actionneur en forme de disque 10. Ce dispositif est connecté aux moyens de commande décrits ci-dessus.

Un tel procédé permet de réaliser un grand nombre de dispositifs à membrane selon l'invention sur une petite surface ce qui rend le dispositif et le procédé particulièrement adapté à la réalisation de haut-parleur digital.

## Revendications

1. Dispositif à membrane comportant un support (4), une membrane (2) suspendue sur le support (4), un premier actionneur (6, 6') destiné à exercer un effort sur la membrane (2), le premier actionneur comportant une périphérie extérieure en contact avec le support (4) et une périphérie intérieure en contact avec la membrane (2), un deuxième actionneur (10, 10') en contact avec la membrane (2) destiné à exercer un effort sur la membrane (2), des moyens de détermination de la position de la membrane par rapport au support et des moyens de commande (C) des premier (6, 6') et deuxième (10, 10') actionneurs, lesdits moyens de commande appliquant un signal de déformation à l'un des premier (6, 6') et deuxième (10, 10') actionneurs pour déplacer la membrane (2) et appliquant un signal de contrôle à l'autre des premier (6, 6') et deuxième (10, 10') actionneurs pour contrôler le déplacement de la membrane (2), l'application du signal de contrôle étant déterminée au moins par la position de la membrane (2).

2. Dispositif à membrane selon la revendication 1, dans lequel les moyens de détermination de la position de la membrane sont au moins en partie portés par la membrane.

3. Dispositif à membrane selon la revendication 1 ou 2, dans lequel ledit signal de contrôle est déterminé en outre par la vitesse et/ou l'accélération du déplacement de la membrane.

4. Dispositif à membrane selon la revendication 1, 2 ou 3, dans lequel les premier (6, 6') et deuxième (10, 10') actionneurs sont du type piézoélectrique, le premier et le deuxième actionneurs comportant respectivement un matériau piézoélectrique disposé entre deux électrodes

5. Dispositif à membrane selon la revendication 4, dans lequel les premier et deuxième actionneurs (6, 6', 0, 10') comportent un matériau piézoélectrique ferroélectrique, chacun des premier (6, 6') et deuxième (10, 10') actionneurs étant destinés à déformer la membrane (2) dans un sens opposé.

6. Dispositif à membrane selon la revendication 4, dans lequel les premier (6, 6) et deuxième (10, 10') actionneurs comportent un matériau piézoélectrique non ferroélectrique, l'un des premier (6, 6') et deuxième (10, 10') actionneurs étant destiné à déformer la membrane (2) dans un premier et un deuxième sens opposés et l'autre des premier et deuxième actionneurs étant destiné à contrôler le déplacement de la membrane (2) en la déformant dans un sens opposé au sens de la déformation induite par l'autre actionneur.

7. Dispositif à membrane selon l'une des revendications 1 à 6, dans lequel la membrane (2) a une forme de disque, le premier actionneur (6) a une forme d'anneau centré sur la membrane (2) et le deuxième actionneur (10) a la forme d'un disque situé sensiblement dans une zone centrale de la membrane (2).

8. Dispositif à membrane selon l'une des revendications 1 à 6, dans lequel la membrane (2) a une forme de disque, le premier actionneur (6') a une forme annulaire centré sur la membrane (2), le premier actionneur (6') comportant une couronne (6.1') et une pluralité d'ailettes (6.2') de forme sensiblement trapézoïdale reliées à la couronne (6.1') par leur grande base, et le deuxième actionneur (10') a la forme d'un disque (2) situé sensiblement dans une zone centrale de la membrane (2).

9. Dispositif à membrane selon l'une des revendications 1 à 8, dans lequel les moyens de commande comportent une boucle de rétroaction négative.

10. Dispositif à membrane selon l'une des revendications 1 à 9, dans lequel les moyens de détermination de la position de la membrane (2) sont de type capacitif.

11. Dispositif à membrane selon la revendication 10, comportant un substrat (13) sur lequel est reporté le support (4), ledit substrat comportant au moins une électrode en regard de la membrane, les moyens de détermination de la position de la membrane mesurant la variation de capacité entre la membrane (2) et ladite électrode sur le substrat

12. Dispositif à membrane selon l'une des revendications 1 à 9, dans lequel les moyens de détermination de la position de la membrane (2) sont de type piézoélectrique.

13. Dispositif à membrane selon la revendication 12 en combinaison avec la revendication 4, dans lequel les moyens de détermination de la position de la membrane (2) sont formés par des électrodes du premier (6, 6') et/ou du deuxième (10, 10') actionneurs, une polarisation électrique étant mesurée sous l'effet de la déformation de la membrane entre les électrodes du premier actionneur (6, 6') et/ou entre les électrodes du deuxième actionneur (10, 10').

14. Dispositif à membrane selon l'une des revendications 1 à 9, dans lequel les moyens de détermination de la position de la membrane (2) sont de type piezorésistif.

15. Haut-parleur digital comportant au moins un dispositif à membrane selon l'une des revendications 1 à 14.

16. Haut-parleur digital selon la revendication 15, comportant une pluralité de dispositifs à membrane de taille micrométrique.

17. Procédé de contrôle de l'actionnement d'un dispositif à membrane selon l'une des revendications 1 à 14 comportant les étapes :
a) application d'un signal de déformation (I) à l'un des premier (6, 6') et deuxième (10, 10') actionneurs,
b) détermination de la position de la membrane (2),
c) détermination d'un signal de contrôle (II),
d) application dudit signal de contrôle (II) à l'autre des premier (6, 6') et deuxième (10, 10') actionneurs.

18. Procédé d'actionnement selon la revendication 17, dans lequel le signal de déformation (I) et le signal de contrôle (II) sont des tensions.

19. Procédé d'actionnement selon la revendication 17 ou 18, dans lequel la détermination de la position de la membrane (2) se fait par mesure d'une polarisation électrique aux bornes du premier (6, 6') et/ou du deuxième (10, 10') actionneurs et/ou par mesure de la capacité entre la membrane (2) et au moins une électrode formée sur le support (13).

## Patentansprüche

1. Membranvorrichtung, umfassend ein Trägerelement (4), eine Membran (2), welche an dem Trägerelement (4) aufgehängt ist, einen ersten Aktuator (6, 6'), welcher dazu vorgesehen ist, eine Kraft auf die Membran (2) einzuwirken, wobei der erste Aktuator einen Außenumfang in Kontakt mit dem Trägerelement (4) und einen Innenumfang in Kontakt mit der Membran (2) umfasst, einen zweiten Aktuator (10, 10') in Kontakt mit der Membran (2), welcher dazu vorgesehen ist, eine Kraft auf die Membran (2) auszuüben, Mittel zum Bestimmen der Position der Membran bezüglich dem Trägerelement und Steuerungsmittel (C) für den ersten (6, 6') und zweiten (10, 10') Aktuator, wobei die Steuermittel ein Deformationssignal an einen aus dem ersten (6, 6') und zweiten (10, 10') Aktuator eingeben, um die Membran (2) zu verlagern, und wobei ein Steuersignal auf den anderen aus dem ersten (6, 6') und dem zweiten (10, 10') Aktuator eingewirkt wird, um die Verlagerung der Membran (2) zu steuern, wobei das Steuersignal wenigstens durch die Position der Membran (2) bestimmt wird.

2. Membranvorrichtung nach Anspruch 1, wobei die Mittel zum Bestimmen der Position der Membran wenigstens teilweise von der Membran getragen sind.

3. Membranvorrichtung nach Anspruch 1 oder 2, wobei das Steuersignal ferner durch die Geschwindigkeit und/oder die Beschleunigung der Verlagerung der Membran bestimmt wird.

4. Membranvorrichtung nach Anspruch 1, 2 oder 3, wobei der erste (6, 6') und zweite (10, 10') Aktuator vom piezoelektrischen Typ sind, wobei der erste und der zweite Aktuator jeweils ein piezoelektrisches Material umfassen, welches zwischen zwei Elektroden angeordnet ist.

5. Membranvorrichtung nach Anspruch 4, wobei der erste und zweite Aktuator (6, 6', 0, 10') ein ferroelektrisches piezoelektrisches Material umfassen, wobei jeder aus dem ersten (6, 6') und dem zweiten (10, 10') Aktuator dazu bestimmt ist, die Membran (2) in eine entgegengesetzte Richtung zu deformieren.

6. Membranvorrichtung nach Anspruch 4, wobei der erste (6, 6') und zweite (10, 10') Aktuator ein nicht ferroelektrisches piezoelektrisches Material umfassen, wobei der eine aus dem ersten (6, 6') und zweiten (10, 10') Aktuator dazu bestimmt ist, die Membran (2) in eine erste Richtung und eine entgegengesetzte zweite Richtung zu deformieren, und der andere aus dem ersten und zweiten Aktuator dazu bestimmt ist, die Verlagerung der Membran (2) zu steuern, indem sie in die entgegengesetzte Richtung zu der Richtung der durch den anderen Aktuator ausgelösten Deformation deformiert wird.

7. Membranvorrichtung nach einem der Ansprüche 1 bis 6, wobei die Membran (2) scheibenförmig ist, wobei der erste Aktuator (6) eine Form eines Rings aufweist, welcher auf der Membran (2) zentriert ist, und der zweite Aktuator (10) die Form einer Scheibe aufweist, welche im Wesentlichen in einem zentralen Abschnitt der Membran (2) positioniert ist.

8. Membranvorrichtung nach einem der Ansprüche 1 bis 6, wobei die Membran (2) eine Form einer Scheibe aufweist, der erste Aktuator (6') eine Form eines Rings aufweist, welcher auf der Membran (2) zentriert ist, der erste Aktuator (6') einen Kranz (6.1') und eine Mehrzahl von Rippen (6.2') mit im Wesentlichen trapezförmiger Form umfasst, welche an dem Kranz (6.1') mit ihrer großen Grundfläche befestigt sind, und der zweite Aktuator (10') die Form einer Scheibe (2) aufweist, welche im Wesentlichen in einem zentralen Bereich der Membran (2) angeordnet ist.

9. Membranvorrichtung nach einem der Ansprüche 1 bis 8, wobei die Steuermittel eine Schleife mit negativer Rückkopplung umfassen.

10. Membranvorrichtung nach einem der Ansprüche 1 bis 9, wobei die Mittel zum Bestimmen der Position der Membran (2) vom kapazitiven Typ sind.

11. Membranvorrichtung nach Anspruch 10, umfassend ein Substrat (13), auf welchem das Trägerelement (4) aufgetragen ist, wobei das Substrat wenigstens eine Elektrode gegenüber der Membran umfasst, wobei die Mittel zum Bestimmen der Position der Membran die Variation der Kapazität zwischen der Membran (2) und der Elektrode auf dem Substrat messen.

12. Membranvorrichtung nach einem der Ansprüche 1 bis 9, wobei die Mittel zum Bestimmen der Position der Membran (2) vom piezoelektrischen Typ sind.

13. Membranvorrichtung nach Anspruch 12 in Kombination mit Anspruch 4, wobei die Mittel zum Bestimmen der Position der Membran (2) durch Elektroden des ersten (6, 6') oder/und des zweiten (10, 10') Aktuators gebildet sind, wobei eine elektrische Polarisation unter der Wirkung der Deformation der Membran zwischen den Elektroden des ersten Aktuators (6, 6') und/oder zwischen den Elektroden des zweiten Aktuators (10, 10') gemessen wird.

14. Membranvorrichtung nach einem der Ansprüche 1 bis 9, wobei die Mittel zum Bestimmen der Position der Membran (2) vom Piezoresistiven Typ sind.

15. Digitaler Lautsprecher, umfassend wenigstens eine Membranvorrichtung nach einem der Ansprüche 1 bis 14.

16. Digitaler Lautsprecher nach Anspruch 15, umfassend eine Mehrzahl von Membranvorrichtungen in Mikrometergröße.

17. Verfahren zum Steuern des Betriebs einer Membranvorrichtung nach einem der Ansprüche 1 bis 14, umfassend die Schritte:
a) Eingeben eines Deformationssignals (I) an den einen aus dem ersten (6, 6') und zweiten (10, 10') Aktuator,
b) Bestimmen der Position der Membran (2),
c) Bestimmen eines Steuersignals (II),
d) Eingeben des Steuersignals (II) an den anderen aus dem ersten (6, 6') und zweiten (10, 10') Aktuator.

18. Verfahren nach Anspruch 17, wobei das Deformationssignal (I) und das Steuersignal (II) Spannungen sind.

19. Verfahren nach Anspruch 17 oder 18, wobei die Bestimmung der Position der Membran (2) durch Messung einer elektrischen Polarisation an Anschlüssen des ersten (6, 6') und/oder zweiten (10, 10') Aktuators vorgenommen wird und/oder durch Messung der Kapazität zwischen der Membran (2) und wenigstens einer an dem Trägerelement (13) gebildeten Elektrode.

## Claims

1. Membrane device comprising a support (4), a membrane (2) suspended on the support (4), a first actuator (6, 6') configured to apply a force on the membrane (2), the first actuator comprising an outer periphery in contact with the support (4) and an inner periphery in contact with the membrane, a second actuator (10, 10') in contact with the membrane (2) configured to apply a force on the membrane (2), means of determining the position of the membrane relative to the support and control means (C) of the first (6, 6') and second (10, 10') actuators, said control means applying a deformation signal to one of the first (6, 6') and second (10, 10') actuators to displace the membrane (2) and applying a control signal to the other of the first (6, 6') and second (10, 10') actuators to control displacement of the membrane (2), application of the control signal being determined at least by the position of the membrane (2).

2. Membrane device according to claim 1, in which the means of determining the position of the membrane are at least partly supported by the membrane.

3. Membrane device according to claim 1 or 2, in which said control signal is also determined by the velocity and/or acceleration of the membrane displacement.

4. Membrane device according to claim 1, 2 or 3, in which the first (6, 6') and second (10, 10') actuators are of piezoelectric type, each of the first and second actuators comprising a piezoelectric material arranged between two electrodes.

5. Membrane device according to claim 4, in which the first and second actuators (6, 6', 0, 10') comprise a ferroelectric piezoelectric material, each of the first (6, 6') and second (10, 10') actuators being configured to deform the membrane (2) in an opposite direction.

6. Membrane device according to claim 4, in which the first (6, 6) and second (10, 10') actuators comprise a non-ferroelectric piezoelectric material, one of the first (6, 6') and second (10, 10') actuators being configured to deform the membrane (2) in a first and second opposite directions and the other of the first and second actuators being configured to control displacement of the membrane (2) by deforming it in a direction opposite to the direction of the deformation induced by the other actuator.

7. Membrane device according to one of claims 1 to 6, in which the membrane (2) is in the form of a disk, the first actuator (6) is in the form of a ring centred on the membrane (2) and the second actuator (10) is in the form of a disk approximately located in a central zone of the membrane (2).

8. Membrane device according to one of claims 1 to 6, in which the membrane (2) is in the form of a disk, the first actuator (6') is annular in shape centred on the membrane (2), the first actuator (6') comprising a ring (6.1') and a plurality of approximately trapezoidal shaped ribs (6.2') connected to the ring (6.1') at their large base, and the second actuator (10') is in the form of a disk (2) located approximately in a central zone of the membrane (2).

9. Membrane device according to one of claims 1 to 8, in which the control means comprise a negative feedback loop.

10. Membrane device according to one of claims 1 to 9, in which the means of determining the position of the membrane (2) are of the capacitive type.

11. Membrane device according to claim 10, comprising a substrate (13) on which the support (4) is transferred, said substrate comprising at least one electrode facing the membrane, the means of determining the position of the membrane measuring the variation in capacitance between the membrane (2) and said electrode on the substrate

12. Membrane device according to one of claims 1 to 9, in which means of determining the position of the membrane (2) are of the piezoelectric type.

13. Membrane device according to claim 12 combined with claim 4, in which the means of determining the position of the membrane (2) are formed by electrodes of the first (6, 6') and/or second (10, 10') actuators, an electrical polarisation being measured under the effect of the membrane deformation between the electrodes of the first actuator (6, 6') and/or between the electrodes of the second actuator (10, 10').

14. Membrane device according to one of claims 1 to 9, in which the means of determining the position of the membrane (2) are of the piezoresistive type.

15. Digital speaker comprising at least one membrane device according to one of claims 1 to 14.

16. Digital speaker according to claim 15, comprising a plurality of micrometric sized membrane devices.

17. Method of controlling actuation of a membrane device according to one of claims 1 to 14 comprising the following steps:
a) apply a deformation signal (I) to one of the first (6, 6') and second (10, 10') actuators,
b) determine the position of the membrane (2),
c) determine a control signal (II),
d) apply said control signal (II) to the other of the first (6, 6') and second (10, 10') actuators.

18. Actuation method according to claim 17, in which the deformation signal (I) and the control signal (II) are voltages.

19. Actuation method according to claim 17 or 18, in which the position of the membrane (2) is determined by measuring an electrical polarisation at the terminals of the first (6, 6') and/or second (10, 10') actuators and/or by measuring the capacitance between the membrane (2) and at least one electrode formed on the support (13).
